(19) Europäisches Patentamt
European Patent Office
Office européen des brevets

(11) EP 2 204 853 A1

(12) **EUROPEAN PATENT APPLICATION**

(43) Date of publication:
07.07.2010 Bulletin 2010/27

(51) Int Cl.:
H01L 31/052 (2006.01)   H01L 31/042 (2006.01)

(21) Application number: 09180890.7

(22) Date of filing: 29.12.2009

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(30) Priority: 31.12.2008 IT RM20080703

(71) Applicant: Convert Italia S.p.A.
00142 Roma (IT)

(72) Inventors:
• De Cataldo, Marco
  00142, ROMA (IT)
• Timidei, Antonio
  00142, ROMA (IT)
• Monaco, Marco
  00142, ROMA (IT)

(74) Representative: Locas, Davide et al
STUDIO ASSOCIATO LEONE & SPADARO
Viale Europa, 15
00144 Roma (IT)

(54) **Photovoltaic plant**

(57) An energy production plant comprises a plurality of photovoltaic tracker devices, each photovoltaic tracker devices comprising at least one photovoltaic element and at least one reflecting element rigidly connected to the photovoltaic element. Each photovoltaic tracker devices is movable about an axis, which is substantially parallel to a longitudinal development direction of the photovoltaic tracker device, according to a law of motion comprising a first step wherein the photovoltaic tracker devices are rotated so as to maximize the exposure of the photovoltaic element to solar beams and a second step wherein the photovoltaic tracker devices remains fixed and/or rotate so as to limit the losses for self-shadowing and for the shadowing created by the adjacent devices

FIG. 1

**EP 2 204 853 A1**

**Description**

The present invention refers to a photovoltaic plant.

A plurality of devices for the production of electric current exploiting the solar energy by means of solar panels is known.

One of the main problems of such devices is connected to the capability of best exploiting the energy provide by sunlight.

In particular, the main aim is to increase the amount of energy absorbed in a photovoltaic plant, thus maximizing the electric energy produced in a year. Such aim, in general, can be obtained by increasing the size of the absorbing surface or enhancing the capacity of energetic absorption of the panels.

It is evident the first aim can be obtained by using more panels and, consequently, a bigger area wherein the plant is placed.

On the contrary, in order to improve the absorbing capability of the plant, several solutions have been developed and, in particular, one possible solution is to use solar panels movable so as to provide a solar tracking. In other words, panel tilting and/or position is varied in the daytime so as to improve the solar beams exposition.

Therefore, such photovoltaic devices are normally called solar tracking devices and they exploit different methods for controlling the solar panels' position. One example of this kind of device is described in U.S. patent No. 4,883,340.

Moreover, these solutions remarkably affects the cost of the plant, while, on the contrary, it should be considered that when such devices are used for big sized plants, it is necessary to optimize both installation and running costs of the plant, even paying great attention to the overall performances.

In particular, tracking plants according to the known art requires a quite complex motion control in other to provide a considerable advantage with respect to the fixed plants, with, in general, a quite high required precision in the mechanical means.

Moreover, just for the installation features of such big sized plants, it is required that they could guarantee a long life, with minimal maintenance and that their performances remains unaltered in the time, without fearing wear caused by meteorological phenomena.

Always in order to improve solar plants performances, in addition to the use of motion systems, also the use of mirrors have been proposed for reflecting sunlight towards a photovoltaic cell. Examples of such plants are described in the patent applications EP 1126529, JP 2002 314112 or DE4433476.

Such patent applications describes solar panels provided with mirrors allowing to concentrate solar beams towards the photovoltaic surface, with the effect of increasing the overall available surface utile of the plant. Nevertheless, these do not provide optimal dimensional feature and motion algorithm and wiring for exploiting reflected beams and accordingly they do not provide an economic return for justifying the use thereof.

Always as an alternative, the international patent application WO 1996 015559 describes a plant wherein a plurality of moving mirrors are used in order to concentrate solar beams towards a photovoltaic element. Nevertheless, such solution is quite complex from a constructive point of view and therefore is hardly large-scale applicable.

Therefore, as a matter of fact, it is not possible to improve the general overall performances of the plant with the above mentioned solutions, also considering the manufacturing and maintenance cost thereof.

Hence, the technical problem underlying the present invention is to provide a photovoltaic plant not presenting the drawbacks mentioned above with reference to the known art.

Such problem is solved by the energy production plant according to claim 1.

The present invention provides several relevant advantages. The main advantage lies in that the method and the panel according to the present invention allow to increase the solar radiation collected by the tracking system, even using a simple mechanical structure such that the system is intrinsically reliable and allowing a improved exploitation of space.

In addition, the plant according to the present invention allows to minimize the problems connected to shadowing produced by the various photovoltaic devices of the plant.

Finally, the wiring used in the plant according to the present invention, allows to optimally exploit the reflected solar beams.

Other advantages, features and the operation modes of the present invention will be made apparent from the following detailed description of some embodiments thereof, given by way of a non-limiting example. Reference will be made to the figures of the annexed drawings, wherein:

figures 1 is a lateral schematic view, showing a photovoltaic tracker device of the plant according to the present invention;
figure 2 is a schematic plan view showing a photovoltaic tracker device of the plant according to the present invention;
figures 3A and 3B are schematic lateral views of two photovoltaic tracker devices wherein solar beams are deviated according to different embodiments, respectively;

figures 4A, 4B and 4C are schematic lateral views showing the motion of the photovoltaic tracker devices of figure 2 during some significant steps of the motion;

figure 5 is a schematic partial perspective view, of a photovoltaic tracker device of the plant according to the present invention according to a different embodiment;

figure 6 is a schematic lateral view of the photovoltaic tracker devices of figure 5;

figure 7 is a schematic lateral view showing the disposition of a pair of photovoltaic tracker devices of figure 5;

figure 8 is a schematic plan view showing the wiring of the by-pass diodes of a photovoltaic module according to the present invention;

figure 9 is a schematic plan view showing the photovoltaic modules of the photovoltaic tracker device of figure 5; and

the figure 10 is a schematic plan view showing the connection of the photovoltaic modules of figure 9.

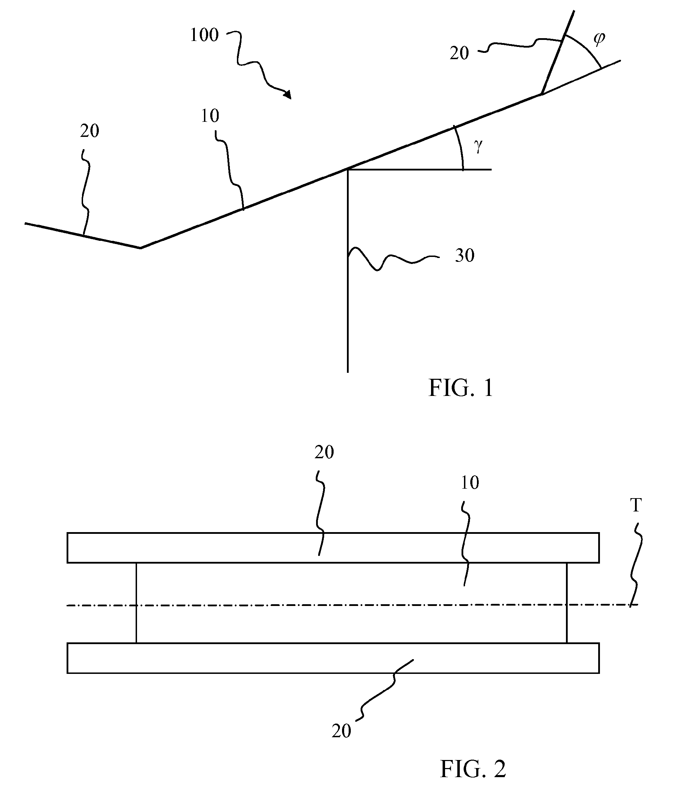

With reference initially to figure 1, a photovoltaic plant according to the present invention is realized by a plurality of photovoltaic tracker devices 100, with a substantially axial development, placed inside a plant occupation area. The device are substantially parallel between them, i.e. according to substantially a row disposition.

As it will be apparent from the following, the photovoltaic devices are defined as tracker as they are capable of modifying their tilting so as to follow the course of the solar beams direction during the day, according to a method that will be described in the following.

Each photovoltaic tracker devices 100, analogously the one used in the plants manufactured according to the known art, comprises a photovoltaic element 10, being in the form of a plan surface extending along the longitudinal development of the photovoltaic tracker device 100. Normally such photovoltaic element 10 is realized by a plurality of photovoltaic modules, also manufactured according to the known art.

Moreover, the photovoltaic tracker device 100 comprises a pair of reflecting elements 20 fixed to respective ends of the photovoltaic element 10. As it will be better described in the following, the reflecting elements 20 are provided to concentrate the solar beams towards the photovoltaic element 10 and, to this purpose, they have a tilting φ relative to plane defined by the surface of the photovoltaic elements 10. Accordingly, as an example, the reflecting elements 20 can be formed by planar mirrors or mirrored metallic surfaces, rigidly fixed to the photovoltaic elements 10.

Moreover, with reference to figures 1 and 2, the photovoltaic tracker devices 100 are rotatable about an axis T, parallel to the longitudinal direction of the photovoltaic elements 10 and placed substantially at the midpoint thereof.

As the reflecting elements 20 are rigidly fixed to the element, they will be accordingly also capable of rotating about axis T.

The photovoltaic tracker device 100 so realized is then fixed to ground by means of suitable supports 30 allowing the moving of the device 100 according to the previously described aspects.

Then, the plant according to the present invention comprises driving and control means of the photovoltaic tracker device 100, allowing to provide the rotation thereof according to the method that will be described in the following.

In general, it should be noted that the photovoltaic tracker device 100 by now described is substantially equivalent to a device used in tracking photovoltaic plants manufactured according to the known art, provided with the reflecting elements 20.

As a consequence, as a matter of fact, the use of the reflecting elements 20 provides the first result of increasing the front section of the device 100 which is exposed to the solar beams than the only surface of the photovoltaic elements. In fact, the section exposed to the solar beams will be formed partly from the surface of the elements, party from the surfaces of the reflecting elements 20.

This allows to maximize the collection of the energy directly provided from the Sun, since the most of the reflected direction consists of direct radiance.

In order to better describe the operation of the device of the plant according to the present invention it could be useful to introduce a concentration factor $k_c$ defined as the ratio between the total front section and the photovoltaic front section:

$$k_c = 1 + \frac{2L'}{L}\cos(\varphi)$$

Wherein $L'$ is the reflecting elements 20 length, L the photovoltaic elements 10 length and φ is the opening angle of the reflecting elements 20 relative to the plane of the elements, as shown in the following figure.

The reflecting elements 20 rotates integral to the plane of the photovoltaic elements 10. Il movement takes place relative to North-South axis and the rotation angle is called $\gamma$ (as shown in figure 1).

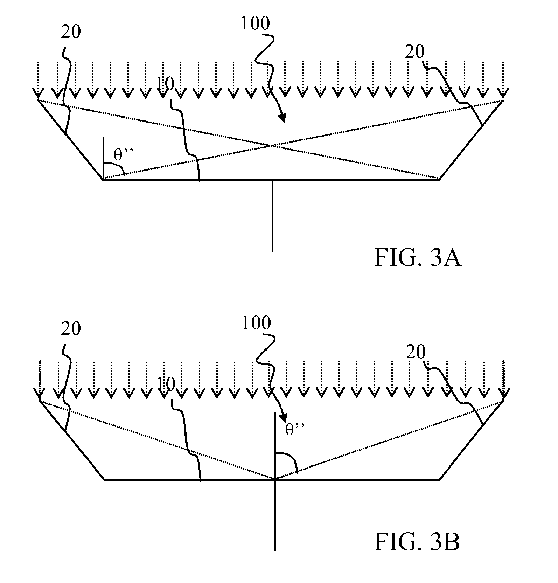

In the equation defining the concentration factor, le quantities $k_c$, $L'$ and φ are related the one to the other and their connection depends on the concentration "model" to be obtained. With reference to figures 3A and 3B it is possible to point out two different embodiments.

Figure 3A shows the case wherein the solar beam reflected by each reflecting element is concentrated on the whole photovoltaic surface. This type of model will be called "full mirror" for the sake of descriptive simplicity.

Figure 3B shows the case wherein the solar beam reflected by each reflecting element is concentrated on half photovoltaic surface. This type of model will be called "half mirror" for the sake of descriptive simplicity.

Expressing the quantities $L'$ and $\varphi$ as functions of $k_c$ it will be possible to obtain for the above mentioned two case respectively:

full mirror:

$$\varphi = \arctan\left(\sqrt{\frac{1+k_c}{3-k_c}}\right)$$

$$L' = \frac{L \cdot \tan\left(2\varphi - \dfrac{\pi}{2}\right)}{\sin(\varphi) - \cos(\varphi) \cdot \tan\left(2\varphi - \dfrac{\pi}{2}\right)}$$

half mirror:

$$\varphi = \arctan\left(\sqrt{\frac{k_c}{2-k_c}}\right)$$

$$L' = \frac{\dfrac{L}{2} \cdot \tan\left(2\varphi - \dfrac{\pi}{2}\right)}{\sin(\varphi) - \cos(\varphi) \cdot \tan\left(2\varphi - \dfrac{\pi}{2}\right)}$$

In practice, once defined the value of the concentration factor $k_c$, parameters $\varphi$ and $L'$ are univocally determined by the above mentioned equations.

The half mirror model represent a significant evolution of the full mirror for the following reasons:

firstly, the concentration factor $k_c$ being the same, the reflected beams are incident on the module with smaller angles (see θ'' in figures 3A and 3B). This allows to diminish the attenuation deriving from the existing when the angle θ'' increases in all photovoltaic elements.

In addition, the laying error relative to the real direction of the solar beams, existing in all tracking systems, damages more the "full mirror" as it involves an higher reduction of the solar beams than the "half mirror".

Anyhow, it should be noted, that in general, differently from other concentrating systems manufactured according to the known art, the proposed one do not require a double axis laying system.

More precisely, considering that the main solar radiation, represented by the direct one, the required tracking consists of about 240° in azimuth and 40° in tilt. The selected tracking system only provides for the azimuth movement, the more important in geometric and thus energetic terms.

Therefore, the laying of the reflecting elements 20 is not affected by azimuth errors, ma only tilt ones. In the plant according to the present invention, the tilt laying error is instead advantageously solved by providing reflecting elements 20 longer than photovoltaic elements 10, as shown in figure 2. In fact, since the reflecting elements 20 and the photovoltaic elements 10 are mounted the one next to the other, the extension relates only the head and the tail of the device, and thus, going from north to south, the first and last reflecting elements 20.

By way of example, the extension of the reflecting elements 20 can be about 2 m South and 0.5 m North and, accordingly, it is minimal compared to the length of the whole tracker, thus involving a very reduced loss that do not non significantly weigh on costs.

The Sun tracking movement is determined by a series of parameters that are from time to time calculated for determining the rotation angle value $\gamma$. Such parameters can be subdivided as follows:

- a) Site parameters: latitude ($\psi$) and longitude (A)
- b) System parameters: azimuth ($\alpha$), tilt ($\beta$), limit angle ($\gamma_{lim}$)
- c) Area parameter: occupancy factor ($F_a$)
- d) Astronomical parameters: hour angle ($\omega$) and declination ($\delta$), both function of hour and day.

More precisely, each photovoltaic tracker devices 100 of the plant is mobile about the above mentioned axis T, substantially parallel to a longitudinal development direction of the device, according to different laws of motion according to the hour of the day and to the period of the year, i.e. to the position of the Sun relative to the plant.

In particular, the motion is subdivided in the following steps:

A first step wherein the photovoltaic tracker devices 100, clear from shadowing, move so as to achieve the greatest effective surface tapping the solar radiation. Such condition can be defined by calling $\theta$ the angle the solar beams defines with the normal to the plane of the photovoltaic elements; as a consequence, the instant rotation angle $\gamma$ value is that value that maximize the value of $\cos\theta$. Accordingly, the rotation angle of the device $\gamma_{opt}$ will be provided by the following expression:

$$\gamma_{opt} = \arctan\left(\frac{-\sin(\alpha)\sin(\psi)\cos(\delta)\cos(\omega) + \cos(\alpha)\cos(\delta)\sin(\omega) + \sin(\alpha)\cos(\psi)\sin(\delta)}{[\sin(\beta)\cos(\alpha)\sin(\psi) + \cos(\beta)\cos(\psi)]\cos(\delta)\cos(\omega) + \sin(\alpha)\sin(\beta)\cos(\delta)\sin(\omega) + [\cos(\beta)\sin(\psi) - \sin(\beta)\cos(\alpha)\cos(\psi)]\sin(\delta)}\right)$$

In such situation both surfaces of the reflecting elements 20 (higher and lower) send solar beams to the plane of the photovoltaic elements 100 increasing the amount of the tapped energy of a value proportional to the concentration factor $k_c$.

This law of motion will be maintained in the device until the self-shadowing phenomenon starts.

More in detail, during the day the sun will follow its motion in the vault of heaven, starting from the solar midday ($\omega = 0$), i.e from the moment wherein the Sun reaches the maximum height. At a certain hour the height of the sun ($h_o$) will have the value

$$\xi_L = \arctan\left(\sqrt{\frac{F_a^2}{1 + F_a^2}}\right)$$

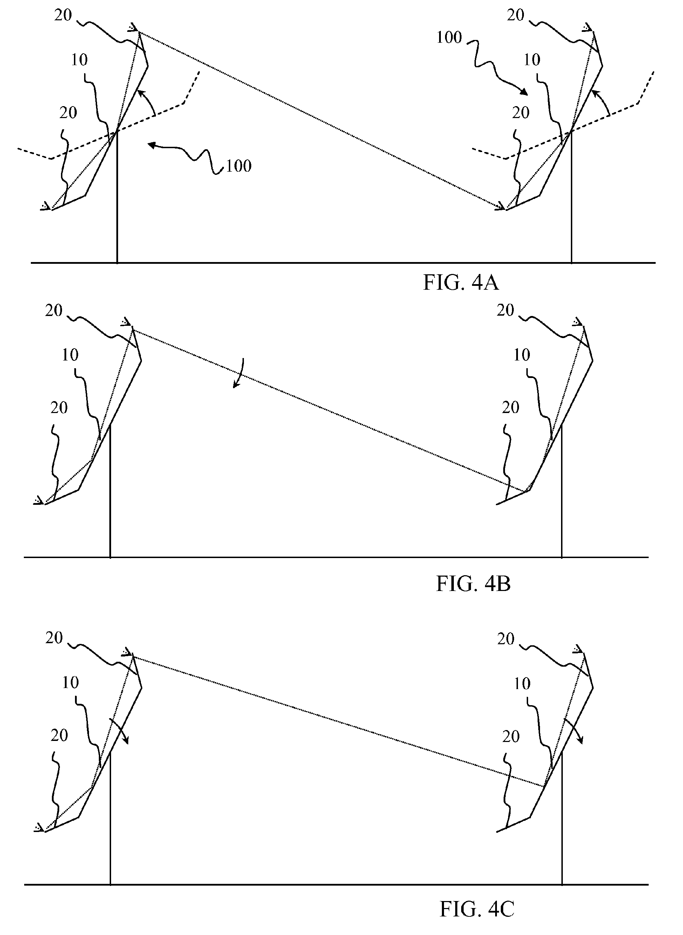

Such value determines the limit after which a row of tracking devices will begin to shadow the next row, in particular overshadowing the reflecting element placed down, as shown in figure 4A. Then, with reference to figure 4B, second step of the motion will follow, wherein the device will remain steady until $h_o = \xi'_L$, wherein

$$\xi'_L = \arctan\left(\sqrt{\frac{(L + L'\cos(\varphi))^2 + (L'\sin(\varphi))^2}{\sqrt{\left(\frac{k_c L}{F_a}\right)^2 - \left[(L + L'\cos(\varphi))^2 + (L'\sin(\varphi))^2\right]}}}\right)$$

I.e., the upper reflecting element 20 will reflect the solar beams on the photovoltaic element 10, thus partly compensating the shadowing generated by the adjacent device 100.

Nevertheless, as the motion of the Sun proceeds, the upper reflecting element 20 will start to illuminate a portion of the shadowed photovoltaic element and, in order to avoid this, the device will proceed his motion as shown in figure 4C.

In particular, the tracking system will move such that the upper reflecting element 20 illuminates the un-shadowed portion of photovoltaic element. As known, the photovoltaic modules forming the photovoltaic elements according to the present invention have a series of diodes for deactivating a part of the module in the case of a portion of the module is shadowed.

Then, in particular the device will move until the shadow produced by the device placed frontally thereto will not be such that the string tension does not fall below the operation lower limit of the inverter. During this step the shadowed area will be *by-passed,* while the extra lighting of the unshadowed area, obtained by the upper reflecting element 20 will allow to maximize the effective tapping surface and, as a consequence, the collected energy.

For the daytime motion, the above mentioned steps are obviously performed in an opposed sequence: at dawn the system starts with the second law of motion, then passing to the first law of motion.

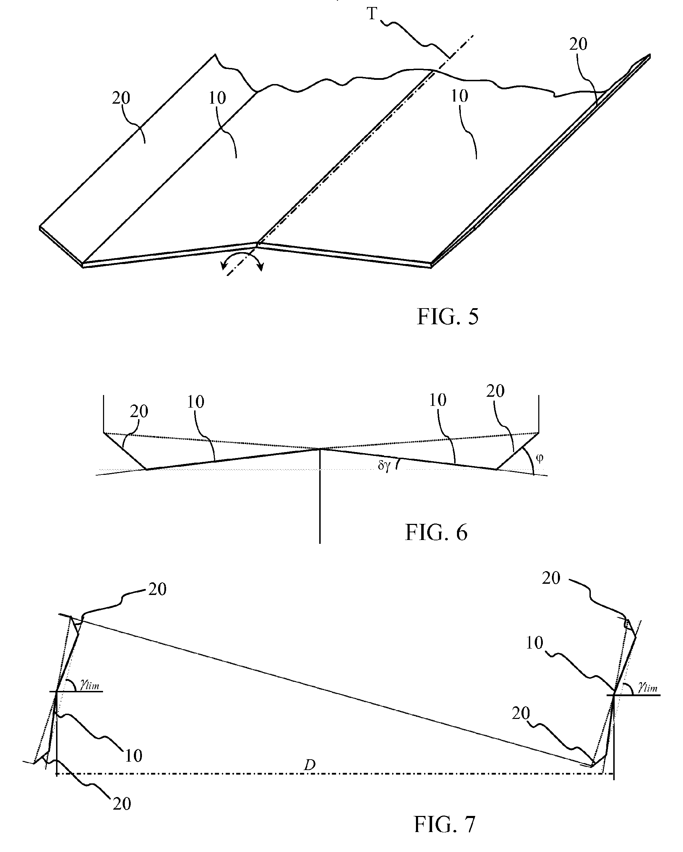

With reference to figure 7, showing a single module 11 with which the photovoltaic element 10 is made, it should be also noted that in most of the known photovoltaic elements comprises *by-pass* diodes 13 for avoiding the flowing of a reverse current in the photovoltaic cells 12 subjected to a lower lighting than the other cells in series. The reverse current could induce a module breaking, the bypass diode allows the flowing of such current along an alternative path to a series of cells 12, typically an amount of cells between 16 and 20.

The cells that are not bypassed can still operate, but normally the tracking systems do not use such possibility as they are direct to an uniform lighting of all the photovoltaic cells.

The second part of the above described law of motion, uses the bypass diodes selecting an angle $\xi'_L$ allowing the reflecting element to carry on laying the cells that are not shadowed.

The calculated angle is then discretized, before being send to the motor. The discretization considers the disposition and size of the cells, of the bypass diodes, typical of the module to be used.

From the point of view of energy production it can be said that the use of the second part of the law of motion allows to improve the production in the time of the day wherein shadows of the adjacent devices are present, without renouncing to the perpendicular laying of the photovoltaic elements 10 and of the reflecting elements 20.

With reference to figures 7 to 9, also a specific solution for the wiring of the bypass diodes in the module is part of the plant according to the present invention. By way of example, figure 7 shows a photovoltaic module having the typical size of 10 x 6, used by several manufactures. This is formed by six columns with ten cells 12 each. The plant according to the present invention using a number of bypass diodes equal to the number of cells columns in the module (it should be noted that the disposition normally used in such modules is rotated of 90° with respect to what is depicted in the figures and to what is normally used in the plants according to the known art). More precisely, the proposed solution uses 6 bypass diodes instead of 3 as normal.

The shadow created by the adjacent devices hits the long side of the module. Then the shadowed area analogously hits the 10 cells disposed in column.

In traditional modules the shadow on the first column involves the conduction of one of the bypass diodes with a consequent deactivation of 20 cells. Instead, in the module in figure the deactivation relates only 10 cells with the following advantages:

- Halving the attenuation from shadow
- Possibility of a more fine discretization of the algorithm in the motion second step, as previously described, always allowing an the selection of the best tracking angle.

Such advantages can also be applied to the "half mirror" and "full mirror" trackers and are also valid for any wiring used, that will be described in detail with reference to a successive embodiment of the invention.

It will be understood that the present invention is susceptible of several embodiments alternative to the one described hereto, some of which are briefly described hereinafter with reference to the sole aspects differentiating them from the first embodiment considered hereto.

Then, with reference to figures 5 and 6, the device 100 could comprise a photovoltaic element having an overall non-planar shape and, in particular, formed by a pair of elements 10 both tilted between them by an angle equal to $180 - 2\delta\gamma$.

More precisely, as can be understood from the figure, a new parameter ($\delta\gamma$) has been introduced, measuring the tilting of the plane of the photovoltaic elements in the present embodiment relative to the plane of the planar faced device previously shown. It should be remembered that the latter plane is the one that during the normal solar tracking motion is the one minimizing the cosine of the angle defined by the incident solar beams and the normal to that tale plane.

For sake of easiness the length of the reflecting element will be described in terms of unit of length of the photovoltaic module ($L/2$), so as to obtain:

$$L' = k_L \cdot \frac{L}{2}$$

Therefore, the effective area $A_{eff}$ tapping the solar beams is defined through the following expression:

$$A_{eff} = L \cdot \left( \cos(\delta\gamma) + r \cdot k_L \cdot \cos(\varphi - \delta\gamma) \right)$$

wherein $r$ is the reflection factor of the reflecting element.

In this new system the concentration factor $k_c$ is obtained from:

$$k_c = \frac{A_{eff}}{L} = \cos(\delta\gamma) + r \cdot k_L \cdot \cos(\varphi - \delta\gamma)$$

Then, it will be possible to find a tern ($\delta\gamma$, $\varphi$, $k_L$) maximizing $k_c$ (or equivalently $A_{aff}$).

The quantities $\delta\gamma$ and $\varphi$ and $k_L$ are connected between them. By making the relationship between such quantities explicit it is possible to obtain the following expression:

$$\delta\gamma(\varphi, k_L) = 2\varphi - \frac{\pi}{2} - arctg\left( \frac{k_L \cdot \sin(\varphi)}{k_L \cdot \cos(\varphi) + 1} \right)$$

By introducing this formula in the equation describing the effective area $A_{eff}$ it is possible to obtain the variation of the effective area versus $\varphi$ and $k_L$, in case assuming $r$ equal to 1 for simplicity.

By plotting in a graph the results of such formula it is possible to see how, per each $k_L$, a value of $\varphi_{ott}$ maximizing $A_{eff}$ exists. As a consequence, according to the previous relationships, it is possible to obtain the corresponding $\delta\gamma_{ott}$ optimizing the solar energy absorption. In this manner a first relevant gain in the performances of a single tracker has been obtained, the size of the reflecting elements 20 and modules being the same, simply by changing the assembling angle.

Also in this embodiment, the plant according to the present invention comprises a plurality of rows of photovoltaic tracker devices 100. As a consequence, when more than one row of tracking devices are used, it is required to consider, as previously described, the reciprocate shadowing of the different rows. With reference then to figure 7, in order to obtain the highest collection of incident solar energy the distance $D$ between the trackers rows is determined by considering the occupancy factor $F_a$ and the maximum rotation angle $\gamma_{lim}$ allowed to the trackers, in the condition that they are shadowed between themselves, when they are tilted by $\gamma_{lim}$.

The relations between the above mentioned parameters are the following:

$$F_a = \cos(\gamma_{lim})$$

$$D = \frac{L}{F_a} \cdot \left\{ \cos\left[ \delta\gamma_{ott}(k_L) \right] + k_L \cdot \cos\left[ \varphi(k_L) - \delta\gamma(k_L) \right] \right\}$$

In this manner all the quantities of the tracker system are defined once the photovoltaic elements 10 and the reflecting elements 20 sizes are known and once the desired occupancy factor has been fixed.

In addition to what has been described with reference to the previous embodiments, the wiring of the single modules 11 defining the photovoltaic element 10 should also be considered.

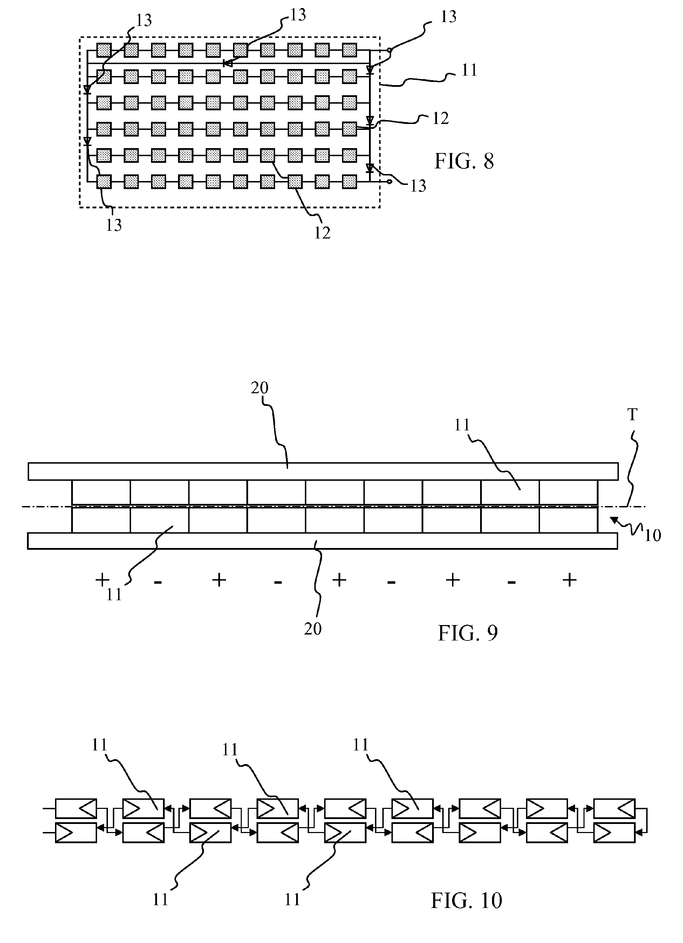

In particular, in the present embodiment the modules are placed on the tracker device as shown in figure 9.

The above mentioned modules are wired connecting the East odd ones the con West even ones (the East first one with the West second one, then with East third one and the West forth one, and so on).

In this way a halving of the attenuation deriving from shadows is provided as half the elements forming the upper row is completely illuminated.

Moreover it should be pointed out that the photovoltaic modules can be connected between then exclusively by means of wires connected thereto, without requiring further additions of wires, that would increase costs and electric losses. In addition, the above mentioned connection avoids the generation of electric noise due to parasitic currents generated by the possible linkage with the magnetic field that are present.

In fact the linkage is realized with opposed signs involving a nullifying of the phenomenon, according to the signs in figure 10. As can be seen in the same figure the electric terminals of the row are disposed on the same side of the tracker, and in this way an amount of electric wire equal to the tracker length is saved.

With reference to the law of motion of the photovoltaic tracker device, with respect to what has been already previously described with reference to the first embodiment, it should be pointed out the motion of the device is formed by a first step, identical to the one previously described, and by a second step, wherein the photovoltaic tracker device remains steady tilted by $\gamma_{lim}$.

Also in this step, what has been previously described with reference to the use of the bypass diodes and of the gradual deactivation of the cells of the module has been applied.

The present embodiment is particularly advantageous thanks to its mechanical structure. In fact, it should be noted that the tilting axis passes from the barycentre of the whole mobile photovoltaic tracker device, whereby it is in a situation of neutral equilibrium. In this way motors almost operates without any load, thus drastically reducing their wear deriving from effort.

Anyhow, it is required to consider some arrangements during the manufacturing f such plants.

The first one relates to the temperature increase of the photovoltaic elements. During design, attention should be paid to the fact that the temperature does not exceeds the maximum operation temperature for the elements, in order to avoid the risk of irreparable damages.

In the Italian territory, the use of concentration factors up to 1.5 is compatible with all the photovoltaic elements available in the market.

The second one relates the choice of the type of the inverter and the size thereof. In order to exploit the concentrating system, it is required to suitably oversize the inverter capacity. It is defined as power peak $\eta_p$, the ratio between power peaks of the plants with reflecting elements 20 and without them. Moreover, as previously mentioned, it is necessary to select an inverter having a wide operating tension range so as to allow the operation thereof during the step of partial shadowing.

By way of example, the data of an example approximating the optimal case intended as the system minimizing the economic pay-back, according to the present definition of costs, are provided in the following.

- conventional 60 cells (1x1,6mt) panels (with only 3 bypass diodes);
- reflecting elements 20 having high reflecting aluminium plates;

The characteristic values of such embodiment are:

L = 2mt (equal to the length of 2 photovoltaic modules);
$k_L$ = 0.6
L' = 0.625mt (comprising an increase factor for correcting errors);
r = 0.92 ö 0.95;
$\delta\gamma$= 10° $\varphi$ = 61° $k_c$ = 1.337 $A_{eff}$ = 2.674;
$F_a$ = 0.3 D = 9.05 $\gamma_{lim}$ = 72.5°;
$\eta_p$ = 1.26

Then, in order to characterize the plant according to the present invention the following performance index can be used:

a) energetic index $\eta_{en}$, defined as the ratio between the energy available at the output of the inverter of a tracer system with mirrors and the one without mirrors. Such index is a function of the concentration factor $k_c$ and of the mirrors reflectivity, other than the site, system and area parameters.
b) economic index $\eta_{ec}$, defined as the ratio between the increase of the income obtained by adding the mirrors and the increase of costs connected thereto. Such index is a function of $\eta_{en}$, of the rate as incentive for the production of energy (proceeds) and of rates for buying and commissioning the concentration system (costs).

These two indexes allow to design the whole photovoltaic plant so as to facilitate the choices in the decision to be taken in order obtain the best possible return of investment.

In the above mentioned exemplificative embodiment, a value of $\eta_{en}$ equal to about 1.22 has been obtained by a mathematical simulation.

Therefore, the above described concentration systems have several advantages that can be summarized as following:

a) increasing the solar radiation connected by the tracking system
b) simple mechanical structure such that the system is intrinsically reliable
c) higher exploitation of the occupancy factor of space than the double axis trackers.

The present invention has hereto been described with reference to preferred embodiments thereof. It is understood that there could be other embodiments referable to the same inventive kernel, all falling within the protective scope of the claims set forth hereinafter.

**Claims**

1.  An energy production plant by means of a plurality of photovoltaic tracker devices (100), each of said photovoltaic tracker devices (100) comprising at least one photovoltaic element (10) and at least one reflecting element (20), said reflecting element (20) being rigidly connected to said photovoltaic element (10) according to a preset tilting, so as to deviate the solar beams which are incident on said reflecting element (20) towards said photovoltaic element (10), **characterized in that** each photovoltaic tracker devices (100) is movable about an axis, which is substantially parallel to a longitudinal development direction of the photovoltaic tracker device (100), according to a law of motion comprising a first step wherein said photovoltaic tracker devices (100) are rotated so as to maximize the exposure of said photovoltaic element (10) to solar beams and a second step wherein the photovoltaic tracker devices (10) remains fixed and/or rotate so as to limit the losses for self-shadowing and for the shadowing created by the adjacent devices.

2.  The plant according to claim 1, wherein the motion of said photovoltaic tracker devices (100) stops when a photovoltaic tracker device (100) begins to shadow the reflecting element (20) of the photovoltaic tracker device (100) adjacent thereto.

3.  The plant according to claim 1 or 2, wherein said law of motion comprises a third step wherein said photovoltaic tracker devices (100) are rotated so that the reflecting element (20) illuminates a non-shadowed portion of the photovoltaic element (10).

4.  The plant according to any of the preceding claims, wherein said photovoltaic devices are rotated during said first step of the law of motion according to a rotation angle $\gamma_{opt}$ given by the expression:

$$\gamma_{opt}= \arctan\left(\frac{-\sin(\alpha)\sin(\psi)\cos(\delta)\cos(\omega)+\cos(\alpha)\cos(\delta)\sin(\omega)+\sin(\alpha)\cos(\psi)\sin(\delta)}{[\sin(\beta)\cos(\alpha)\sin(\psi)+\cos(\beta)\cos(\psi)]\cos(\delta)\cos(\omega)+\sin(\alpha)\sin(\beta)\cos(\delta)\sin(\omega)+[\cos(\beta)\sin(\psi)-\sin(\beta)\cos(\alpha)\cos(\psi)]\sin(\delta)}\right)$$

wherein:

$\psi$ is the latitude and A the longitude of the device;
$\alpha$ the azimuth, $\beta$ the tilt angle and $\gamma_{lim}$ the limit angle of the device;
$\omega$ the hour angle and $\delta$ the declination, both function of hour and date.

5.  The plant according to any of the preceding claims, wherein said photovoltaic tracker device (100) comprises at least a pair of photovoltaic elements (10), said photovoltaic elements (10) being slanting therebetween by a predetermined angle.

6.  The plant according to claim 5, wherein said photovoltaic elements (10) are rigidly connected therebetween at an end thereof, substantially corresponding to the tilting axis (T) of the device (100), so that they are both slanting by a predetermined angle ($\delta\gamma$) to a reference planar surface passing through said tilting axis (T) and comprises a pair of reflecting elements (20) placed on respective opposed ends of said photovoltaic elements (10).

7. The plant according to claim 6, wherein each element of said pair of photovoltaic elements (10) comprises a plurality of photovoltaic modules (11), the modules (11) of a first photovoltaic element (10) being alternatively connected to the modules (11) of the second photovoltaic element (10).

8. The plant according to any of the preceding claims, wherein said photovoltaic elements (10) comprise a plurality of photovoltaic modules (11), in turn formed by plurality of photovoltaic cells (12) serially arranged on parallel lines, and further comprising a by-pass diode (13) for each line of photovoltaic cells (12), so that it is possible to individually cut out each line of shadowed photovoltaic cells (12).

9. The plant according to any of the preceding claims, wherein said reflecting element (20) have a wider longitudinal extension than a said photovoltaic element (10).

10. The plant according to any of the preceding claims, comprising a pair of reflecting elements (20) rigidly connected to opposed ends of said photovoltaic element (10), each reflecting element (20) being slanting to a development surface of said photovoltaic element (10), so that, during said first step of the law of motion, each of said reflecting elements (20) turns a solar beam so as to illuminate said photovoltaic element (10) by an area having an extension substantially equal to half the overall area of said photovoltaic element (10).

100

20

10

20

10

γ

φ

30

FIG. 1

20

10

T

20

FIG. 2

FIG. 3A

FIG. 3B

FIG. 4A

FIG. 4B

FIG. 4C

FIG. 5

FIG. 6

FIG. 7

FIG. 8

FIG. 9

FIG. 10

Europäisches
Patentamt
European
Patent Office
Office européen
des brevets

# EUROPEAN SEARCH REPORT

Application Number

EP 09 18 0890

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/251569 A1 (SHAN WEI [US] ET AL SHAN WEI [US] ET AL) 1 November 2007 (2007-11-01) * paragraphs [0004] - [0010], [0013], [0018], [0054], [0058], [0064]; claims 1-4,16; figures 1,3,4 * | 1-3 | INV. H01L31/052 H01L31/042 |
| A | US 2007/193620 A1 (HINES BRADEN E [US] ET AL) 23 August 2007 (2007-08-23) * paragraphs [0012] - [0016], [0018], [0049] - [0051], [0060], [0077], [0084]; claims 1-5; figures 1A,1B,2A,2B,5,10-13 * | 1,8-10 | |
| A,D | DE 44 33 476 A1 (BUSCH PETER DIPL ING [DE]) 23 March 1995 (1995-03-23) * the whole document * | 1,8,10 | |
| A,D | JP 2002 314112 A (SUMITOMO 3M LTD) 25 October 2002 (2002-10-25) * abstract; figures 1-4,7 * | 1,5-6, 8-10 | TECHNICAL FIELDS SEARCHED (IPC) |
| A | US 2002/075579 A1 (VASYLYEV SERGIY VICTOROVICH [US] ET AL) 20 June 2002 (2002-06-20) * the whole document * | 1,3,8-10 | H01L F24J |
| A | WO 2008/152162 A (BALERDI ETXANIZ MODESTO [ES]; CUNILL GUTIERREZ JAUME [ES]) 18 December 2008 (2008-12-18) * claims 1-9; figures 1-9 * | 1,8 | |

The present search report has been drawn up for all claims

| Place of search | Date of completion of the search | Examiner |
|---|---|---|
| Berlin | 23 March 2010 | Visentin, Alberto |

EPO FORM 1503 03.82 (P04C01)

**ANNEX TO THE EUROPEAN SEARCH REPORT
ON EUROPEAN PATENT APPLICATION NO.**

EP 09 18 0890

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2010

| Patent document cited in search report | | Publication date | Patent family member(s) | Publication date |
|---|---|---|---|---|
| US 2007251569 | A1 | 01-11-2007 | NONE | |
| US 2007193620 | A1 | 23-08-2007 | NONE | |
| DE 4433476 | A1 | 23-03-1995 | NONE | |
| JP 2002314112 | A | 25-10-2002 | NONE | |
| US 2002075579 | A1 | 20-06-2002 | NONE | |
| WO 2008152162 | A | 18-12-2008 | ES 2310966 A1 | 16-01-2009 |

For more details about this annex : see Official Journal of the European Patent Office, No. 12/82

**REFERENCES CITED IN THE DESCRIPTION**

**Patent documents cited in the description**

- US 4883340 A
- EP 1126529 A
- JP 2002314112 A
- DE 4433476
- WO 015559 A